# EUROPEAN PATENT APPLICATION

(11) **EP 1 865 609 A1**
(43) Date of publication of application: **12.12.2007**
(21) Application number: 06730594.6
(22) Date of filing: 30.03.2006
(51) Int. Cl.: H04B 1/18, H03G 3/30, H03H 7/25

(54) **SIGNAL ATTENUATING CIRCUIT**

(30) Priority: 31.03.2005 JP 2005102794
(71) Applicant: Pioneer Corporation, Tokyo 153-8654 (JP)
(72) Inventor: KOSUGA, Tadashi, Pioneer Corporation, Kawagoe-shi, Saitama 350-8555 (JP)
(74) Representative: Haley, Stephen
(86) International application number: PCT/JP2006/306646
(87) International publication number: WO 2006/106816

(57) **Abstract**

A high-frequency signal which is induced in an antenna 1 is attenuated according to an impedance of a rectifier element D1 determined by a size of an attenuation factor control signal AGC. On the other hand, when a low-frequency interference such as a power-transmission line interference is generated, and an amplitude of the signal induced in the antenna 1 fluctuates substantially at a low frequency, by a circuit which is formed by a resistor R11 and a diode D1, or a circuit which is formed by the resistor R11, a diode D2, and a resistor R12, a voltage of a low-frequency signal originated from the low-frequency interference is clamped. As a result of this, a level of an input signal to a subsequent signal processing circuit 2 is optimized.

## Description

### TECHNICAL FIELD

The present invention relates to a signal attenuation circuit which attenuates a signal from a signal source, and sends an attenuated signal to a subsequent signal processing circuit.

### BACKGROUND ART

Receivers of which, a radio receiver is a typical example, have hitherto been used widely. In such receivers, at the time of processing a signal induced in an antenna, it is a general practice to carry out a frequency conversion and detection, after letting a size of the signal to be favorable for the processing. At the time of converting the size of the signal from such signal source, an automatic gain control (AGC) method in which, a signal from the signal source is input to an amplification means via an attenuation means, and an attenuation factor in the attenuation means is adjusted, based on a detection result in a subsequent stage of the amplification means, has been used in many receivers.

Moreover, in a case of a receiver which performs reception directly beneath a transmission line of electric power, such as a radio receiver onboard a car, in a country which has adopted an AC (Alternating Current) transmission as our country (Japan), it is not possible to avoid receiving low-frequency interfering waves of a power-transmission frequency (50 Hz or 60 Hz in our country (in Japan)) (hereinafter called as 'transmission line interference'). A size of the transmission line interference which is a sort of low-frequency interfering waves, depends on a distance from the transmission line, and an amplitude might reach up to about 100 V, and an input signal level to a high-frequency amplifier which is an initial state amplifier in the receiver might go out of a proper operation range of the high-frequency amplifier. Such situation had been generating a distortion and a cross modulation in an amplification result by the high-frequency amplifier, and resulting in hum noise in a case of a radio receiver.

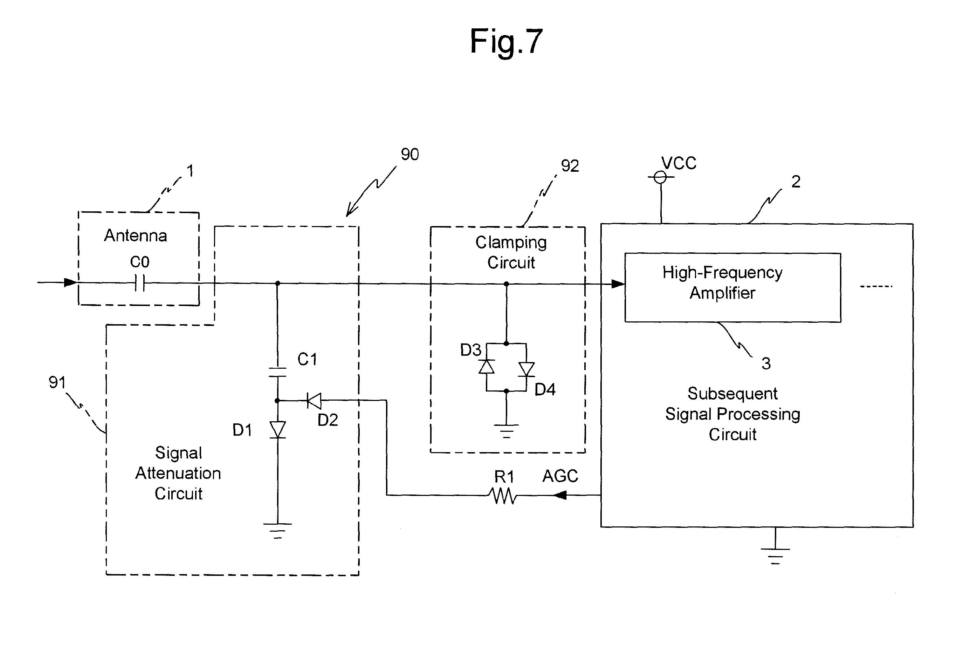

In order to prevent this situation, and to realize an automatic gain control (AGC), letting the receiver to be a receiver 90 in which a circuit structure shown in Fig. 7 can be taken into consideration (hereinafter called as 'conventional example 1'). This receiver 90 comprises (a) an antenna 1 which is indicated by a capacitor C0 as an equivalent circuit, (b) a signal attenuation circuit 91 which attenuates a signal induced in the antenna 1 to an attenuation factor according to a size of an attenuation factor control signal AGC, (c) a clamping circuit 92 which clamps a signal which is via the signal attenuation circuit 91, and (d) a subsequent signal processing circuit 2 which processes a signal which is via the clamping circuit 92. Here, an arrangement is such that the attenuation factor control signal AGC is generated in the subsequent signal processing circuit 2, and is supplied to the signal attenuation circuit 91 via a resistor R1.

The signal attenuation circuit 91 comprises (i) diodes D1 and D2 connected in series, (ii) a capacitor C1 of which, one terminal is connected to a contact point of the diode D1 and the diode D2, and the other terminal is connected to a signal output terminal of the antenna 1. Moreover, a cathode terminal of the diode D1 is grounded, and an anode terminal of the diode D2 is connected to a terminal which is different from an input terminal of the attenuation factor control signal AGC of the resistor R1.

The clamping circuit 92 includes diodes D3 and D4. Here, an anode terminal of the diode D3 is grounded, a cathode terminal of the diode D3 is connected to a signal input terminal of the high-frequency amplifier 3. Moreover, a cathode terminal of the diode D4 is grounded, and an anode terminal of the diode D4 is connected to the signal input terminal of the high-frequency amplifier 3.

In the receiver 90, in the signal attenuation circuit 91, a level loss according to an impedance value of the diodes D1 and D2 determined according to the size of the attenuation factor control signal AGC, is generated in a signal from the antenna 1. The signal subjected to such level loss is input to the clamping circuit 92. In the clamping circuit 92, when the input signal has a substantial voltage on a positive side or a negative side with respect to a ground level, a clamping process by the diode D3 or the diode D4 is carried out. As a result of this, an optimization of the level of signal which is input to the high-frequency amplifier 3 of the subsequent signal processing circuit 2 is facilitated.

Moreover, for achieving the optimization of the level of the signal input to the subsequent signal processing circuit 2, a receiver 95 in which a circuit structure shown in Fig. 8 is adopted, has also been proposed (Refer to Patent Literature 1; hereinafter called as 'conventional example 2'. In this receiver 95, the signal attenuation circuit 91 and the clamping circuit 92 in the receiver 90 described above, are replaced by a signal attenuation circuit 96. This signal attenuation circuit 96 comprises, in addition to the components of the signal attenuation circuit 91 mentioned above, a resistor R2 of which, one terminal is connected to the contact point of the diode D1 and the diode D2, and the other terminal is connected to the signal output terminal of the capacitor C1.

In the receiver 95, regarding a high-frequency signal induced in the antenna 1, similarly as in a case of the receiver 90, the level loss according to the impedance value of the diodes D1 and D2 determined according to the size of the attenuation factor control signal AGC, is generated. Moreover, when in the signal induced in the antenna, there exists a low-frequency signal originated from a low-frequency interference wave having a substantial voltage on a positive side with respect to the ground level, regarding the low-frequency signal, a level loss which is determined by a ratio of a combined impedance of an impedance of the resistor R2, an impedance of the capacitor C1, and an impedance of the diode D1 in a rectification direction, to an impedance of the antenna 1, is generated. In this manner, in the receiver 95, the optimization of the input signal level to the high-frequency amplifier 3 of the subsequent signal processing circuit 2 is facilitated.

In the description of the receiver 95, same reference numerals were used for components which are same or similar in the case of the receiver 90, and the description to be repeated was omitted.

Patent Literature 1: Japanese Patent Application Laid-open Publication No. Hei 09(1997)-135180.

### DISCLOSURE OF THE INVENTION

### PROBLEMS TO BE SOLVED BY THE INVENTION

Both the technologies of the conventional example 1 and the conventional example 2 mentioned above are technologies in which, characteristics of diode as a rectifier element which is a non-linear response element having a directionality for an ease of flowing of electric current, are used. Here, in the technology of the conventional example 1, a level of the signal which is input to the subsequent signal processing circuit 2 is limited by the clamping circuit 92 which is formed by two diodes D3 and D4. Therefore, the technology of the conventional example 1 is superior from a point of view that even when the signal received by the antenna has a substantial voltage on a positive side with respect to the ground level, and even when has a substantial voltage on a negative side with respect to the ground level, it is possible to optimize the level of the signal input to the subsequent signal processing circuit 2.

On the other hand, in the technology of the conventional example 2 mentioned above, the diode D1 of the signal attenuation circuit 96 is used for signal attenuation as well as for signal clamping. Therefore, we would have to say that a rectifier means such as a diode is inferior as compared to a resistor and a capacitor, from a point of view of a long-term operation safety. Moreover, it is expensive. When these factors are taken into consideration, as compared to the technology of the conventional example 1, it is superior although there is an increase in the number of resistive elements, but from a point that it is possible to reduce the number of diodes, which are rectifier means. However, in the technologies of the conventional examples, when the signal received by the antenna has a substantial voltage on the positive side with respect to the ground level, it is possible to optimize the level of the signal input to the subsequent signal processing circuit 2, by a circuit which is formed by the diode D1 and the resistor R2, but when the signal received by the antenna has a substantial voltage on the negative side with respect to the ground level, it was not possible to optimize the level of the signal input to the subsequent signal processing circuit 2.

The present invention is made in view of the situation described above, and an object of the present invention is to provide a novel signal attenuation circuit which is capable of contributing to the automatic gain control, and to institute measures against the low frequency interfering waves.

### MEANS FOR SOLVING THE PROBLEMS

A signal attenuation circuit of the present invention is the signal attenuation circuit which attenuates a signal from a signal source, and sends an attenuated signal to a subsequent signal processing circuit, comprising: a first rectifier means which has one terminal which is connected to an output terminal of the signal source and an input terminal of the subsequent signal processing circuit, via a first impedance, and the other terminal which is connected to an alternating ground level via a second impedance, and for which, an impedance changes according to a size of an attenuation factor control signal; and a second rectifier means which has one terminal which is connected to the alternating ground level via a third impedance, and the other terminal which is connected to one terminal of the first rectifier means, and which is connected in series to the first rectifier terminal in a rectification direction, and for which, an impedance changes according to the size of the attenuation factor control signal, wherein the first impedance, the second impedance, and the third impedance are determined upon considering an attenuation of the signal from the signal source, by a change in the impedance of the first rectifier means and the second rectifier means, according to a size of the attenuation factor control signal, in a high-frequency region in which the subsequent signal processing circuit has to perform processing, and are determined upon considering a proper range of an input signal level of the subsequent signal processing circuit and the impedance of the signal source, in a low-frequency region in which a low-frequency interference may be generated. Here, the 'rectifier means' is defined as an element which has a directionality for an ease of flowing of electric current, and which makes a non-linear response, or a combination of such elements, and 'rectification direction' is defined as a direction in which the electric current is susceptible to flow in the rectifier means. In the present invention, terms 'rectifier means' and 'rectification direction' are used in this sense.

In this signal attenuation circuit, the first impedance, the second impedance, and the third impedance are determined upon considering the attenuation of the signal from the signal source, by the change in the impedance of the first rectifier means and the second rectifier means according to the size of the attenuation factor control signal, in the high-frequency region in which the subsequent signal processing circuit has to perform processing. Therefore, in a case of the high-frequency signal, it is subjected to a level loss according to the impedance of the first rectifier means and the second rectifier means determined by the size of the attenuation factor control signal, and the signal from the signal source is attenuated properly.

Moreover, in the low-frequency region in which the low-frequency interference may be generated, when a rectification direction of the first rectifier means is let to be a direction from the one terminal to the other terminal of the first rectifier means, during a period of having a voltage on a positive side with respect to the alternating ground level, the level loss determined by a ratio of a combined impedance of the first impedance, an impedance in the rectification direction of the first rectifier means, and the second impedance, to an impedance of the signal source, is generated. Moreover, during a period of having a voltage on a negative side with respect to the alternating ground level, the level loss determined by a ratio of a combined impedance of the first impedance, an impedance in the rectification direction of the second rectifier means, and the third impedance, to the impedance of the signal source, is generated.

Here, in the low-frequency region in which the low-frequency interference may be generated, the first impedance, the second impedance, and the third impedance are determined upon considering the impedance of the signal source and the proper range of the level of the signal which is input to the subsequent signal processing circuit and the impedance of the signal source. Therefore, even when the low-frequency interference is generated, it is accommodated in the proper range of the input signal level of the subsequent signal processing circuit.

In the signal attenuation circuit of the present invention, a structure can also be let to be such that the signal output terminal of the signal source and the one terminal of the first rectifier means are connected via a capacitive element, and is connected in parallel to a connection made via the capacitive element, via a resistive element, and the structure can also be let to be such that the signal output terminal of the signal source, and the one terminal of the first rectifier means are connected directly, and the first impedance is let to be substantially zero. Moreover, in the signal attenuation circuit of the present invention, the structure can also be let to be such that the other terminal of the first rectifier means and the alternating ground level are connected directly, and the second impedance is let to be substantially zero, and the structure can also be let to be such that the one terminal of the second rectifier means and the alternating ground level are connected directly, and the third impedance is let to be substantially zero.

In the signal attenuating circuit of the present invention, it is possible to adopt a diode as the first rectifier means and the second rectifier means.

### BRIEF DESCRIPTION OF DRAWINGS

Fig. 1 is a diagram showing a circuit structure of a receiver which comprises a signal attenuation circuit of the an embodiment of the present invention;
Fig. 2 is a diagram for describing an example of a signal waveform at an input terminal of a high-frequency amplifier in the receiver in Fig. 1;
Fig. 3 is a diagram for describing an example of a signal waveform of a comparative example;
Fig. 4 is a diagram showing a circuit structure of a receiver which comprises a signal attenuation circuit of a first modified example;
Fig. 5 is a diagram showing a circuit structure of a receiver which comprises a signal attenuation circuit of a second modified example;
Fig. 6 is a diagram showing a circuit structure of a receiver which comprises a signal attenuation circuit of a third example embodiment;
Fig. 7 is a diagram showing a circuit structure which comprises a signal attenuation circuit of a conventional example 1; and

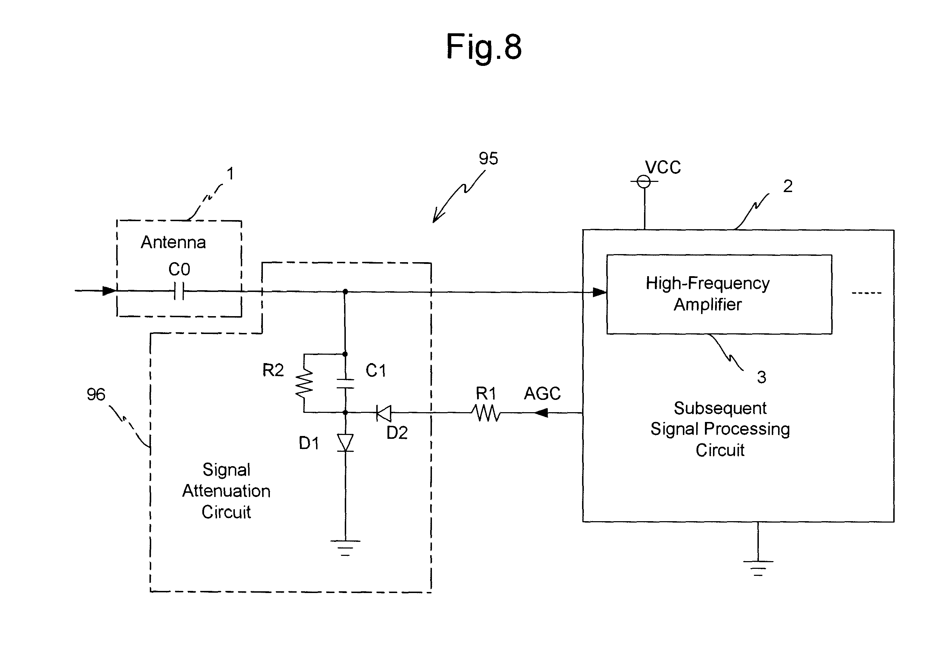

Fig. 8 is a diagram showing a circuit structure which comprises a signal attenuation circuit of a conventional example 2.

### BEST MODE FOR CARRYING OUT THE INVENTION

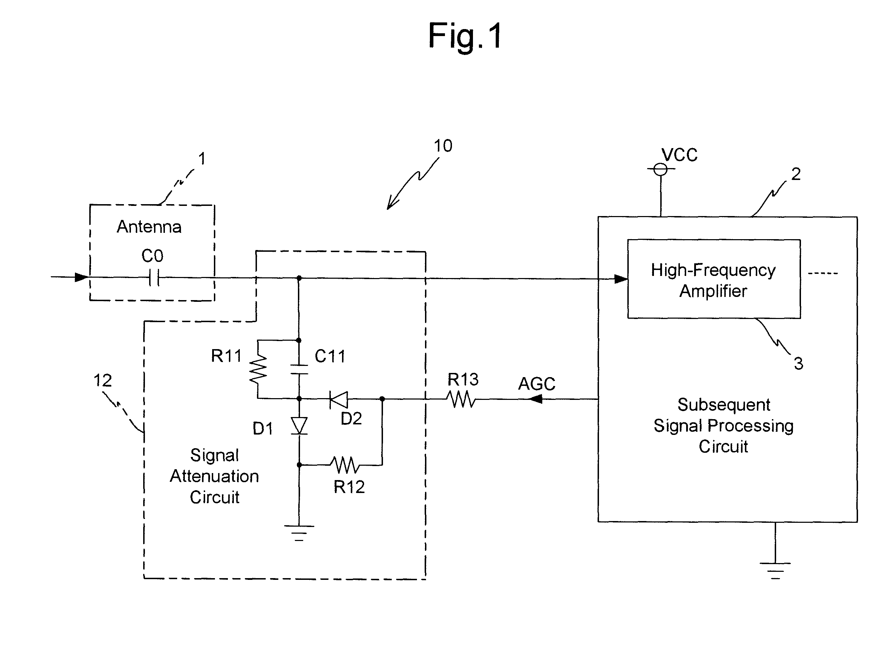

An embodiment of the present invention will be described below by referring to Fig. 1 to Fig. 3.

In Fig. 1, a structure of a receiver 10 which comprises a signal attenuation circuit 12 according to the embodiment of the present invention is shown. As shown in Fig. 1, the receiver 10 comprises in addition to the signal attenuation circuit 12, (a) an antenna 1, and (b) a high-frequency amplifier 3 in an initial stage, and a subsequent signal processing circuit 2 which processes a signal which is input via the signal attenuation circuit 12 after being received by the antenna 1. Here, an arrangement is such that an attenuation factor control signal AGC, similarly as in case of the receivers 90 and 95 described above, is generated in the subsequent signal processing circuit 2, and is supplied to the signal attenuation circuit 12 via a resistor R13. The attenuation factor control signal AGC is generated based on a detection result of a signal amplified by the high-frequency amplifier 3, and a detection result at a subsequent stage of the high-frequency amplifier 3.

The signal attenuation circuit 12 comprises a diode D1, a diode D2, a capacitor C11, a resistor R11, and a resistor R12. Here, a cathode terminal of the diode D1 is grounded, and an anode terminal of the diode D1 is connected to a cathode terminal of the diode D2. The attenuation factor control signal AGC is input to an anode terminal of the diode D2, via the resistor R13.

Moreover, one terminal of the capacitor C11 is connected to a signal output terminal of the antenna, and a signal input terminal of the high-frequency amplifier 3 of the subsequent signal processing circuit 2, and the other terminal of the capacitor C11 is connected to the anode terminal of the diode D1. Furthermore, one terminal of the resistor R11 is connected to the signal output terminal of the antenna 1, and the signal input terminal of the high-frequency amplifier 3 of the subsequent signal processing circuit 2, and the other terminal of the resistor R11 is connected to the anode terminal of the diode D1. One terminal of the resistor R12 is grounded, and the other terminal of the resistor R12 is connected to the anode terminal of the diode D2.

As a capacitance value of the capacitor C11, a capacitance value similar to a capacitance value of a capacitor C1 in the conventional example 1 is selected. Moreover, as a resistance value of the resistor R13, a resistance value similar to a resistance value of the conventional example 1 is selected.

As a resistance value of the resistor R11, for a frequency range of a component originated from the low-frequency interference, a value sufficiently smaller than an impedance of a capacitor C0 which is an equivalent circuit of the antenna 1 and an impedance of the capacitor C11, is selected. Moreover, as a resistance value of the resistor R12, for the frequency range of the component derived from the low-frequency interference, a value for which the sum with the resistance value of the resistor R11 is sufficiently smaller than the impedance of the capacitor C0 which is an equivalent circuit of the antenna 1, and which is capable of changing the impedance of the diodes D1 and D2 in a sufficient range from a point of view of automatic gain control, by the attenuation factor control signal AGC which is via the resistor R13, is selected.

For example, in a case in which the antenna 1 is a rod antenna, when the capacitance value of the capacitor C0 is about 80 pF, and the frequency of the low-frequency interference is assumed to be in a range of 50 Hz to 60 Hz, the impedance of the capacitor C0 is in a range of about 33 MΩ to 40 MΩ. In this case, for clamping the low-frequency interference of an amplitude of about 100 V to an amplitude of a few hundred mV, and to let it to be accommodated in an input proper voltage range of the high-frequency amplifier 3, the resistance value of the resistor R11 and the resistor R12 is not more than about few hundred kΩ. According to the resistance value of the resistor R12 selected in such range, the resistance value of the resistor R13 is selected such that the impedance of the diodes D1 and D2 can be changed in a sufficient range from the point of view of automatic gain control, by the attenuation factor control signal AGC.

An operation of the receiver 10 structured as mentioned above, will be described below.

When a high-frequency signal which is to be processed by the subsequent signal processing circuit 2, such as a broadcast-wave signal which is induced in the antenna 1 is a voltage not higher than a sensitivity related to an automatic gain control operation set in the receiver 10, the high-frequency signal, without being attenuated by the signal attenuation circuit 12, is input to the high-frequency amplifier 3 of the subsequent signal processing circuit 2. Since an impedance in a direction opposite to the rectification direction of the diode D2 is extremely high, and there is no current supply made by the attenuation factor control signal AGC, an impedance in the rectification direction of the diode D1 becomes an extremely high value.

Moreover, when an amplitude of the high-frequency signal induced in the antenna 1 becomes increases, and the voltage becomes a voltage beyond the sensitivity related to the automatic gain control operation, an attenuation command is made by an electric current supply made by the attenuation factor control signal AGC, and the impedance of the diodes D1 and D2 change. As a result of this, the anode terminal of the diode D1 assumes positive level. Moreover, a level loss which is determined by a ratio of combined impedance of the impedance of the capacitor C11, the impedance of the resistor R11, and the impedance in the rectification direction of the diode D1, to the impedance of the antenna 1, is generated for the high-frequency signal, and the high-frequency signal induced in the antenna 1 is attenuated.

In the manner described above, the level of the high-frequency signal induced in the antenna 1 is optimized, and the signal is input to the high-frequency amplifier 3.

On the other hand, the signal induced in the antenna 1, when a low-frequency signal of about a frequency of the low-frequency interference such as a power-transmission line interference is superimposed, since the impedance of the resistor R11 for this low-frequency signal is sufficiently smaller than the impedance of the capacitor C11, the signal attenuation circuit 12 performs an operation similar to a case when there is no impedance of the capacitor C11. In other words, during a period in which the low-frequency signal has a voltage on the positive side, the voltage value becomes approximately a voltage value which is determined by a ratio of a combined impedance of the impedance of the resistor R11 and the impedance in the rectification direction of the diode D1, to the impedance of the antenna 1. Moreover, during a period in which the low-frequency signal has a voltage on the negative side, the voltage value becomes approximately a voltage value which is determined by a ratio of a combined impedance of the impedance of the resistor R11, an impedance in the rectification direction of the diode D2, and the impedance of the resistor R12, to the impedance of the antenna 1.

Here, taking into consideration that the impedance of the antenna 1 is sufficiently larger than the impedance of the resistor R11 and the impedance of the resistor R12, for the low-frequency signal of about a frequency of the low-frequency interference, when the amplitude of the low-frequency signal is large, the abovementioned operation can be said to be the same clamping operation similar to the clamping process operation by the clamping circuit 92 in the conventional example 1, and the result is also same as the result of the clamping process by the clamping circuit 92 in the conventional example 1. Therefore, even when the signal induced in the antenna 1 becomes a signal with the low-frequency signal of high amplitude superimposed thereon, the level of the signal input to the high-frequency amplifier 3 is optimized.

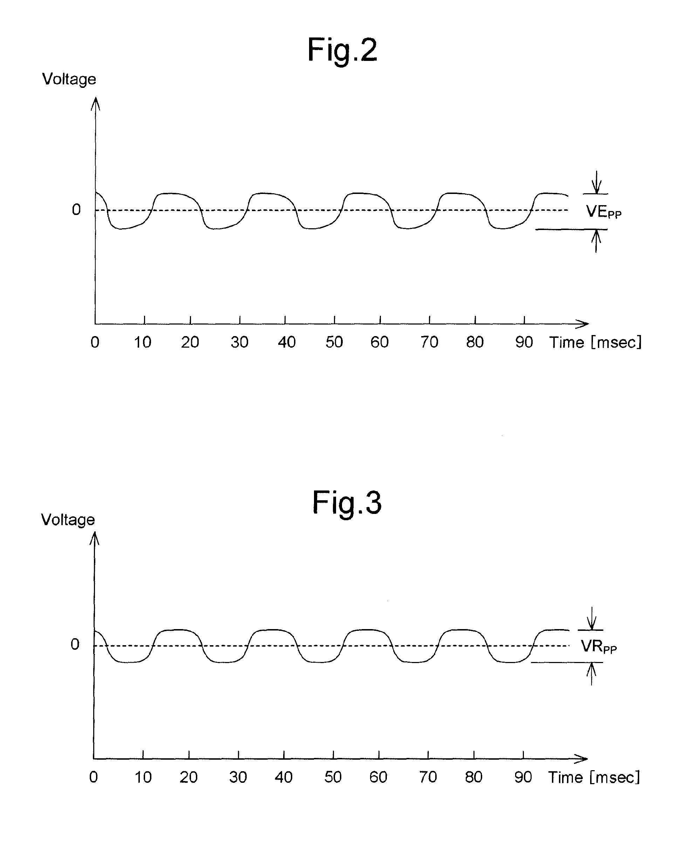

For confirming an optimization operation of the level of the signal input to the high-frequency amplifier 3 in the receiver 10 of the present invention, a receiver was made for an experimental purpose, in which a capacitance value of the capacitor C0 which is an equivalent circuit of the antenna 1 was let to be 80 pF, a capacitance value of the capacitor C11 was let to be 3300 pF, a resistance value of the resistor R11 was let to be 4.7 kΩ, a resistance value of the resistor R12 was let to be 4.7 kΩ, and for the diodes D1 and D2, P-N junction diodes which normally available in the market were used. Furthermore, an experiment in which, when the signal output terminal is in an open state, a low-frequency interfering waves which becomes a low-frequency signal having the maximum-minimum amplitude of 100 V and 50 Hz is applied to the antenna 1, was carried out. In this case, a waveform at the output terminal of the signal attenuation circuit 12 was as shown in Fig. 2, and the maximum-minimum amplitude VE_{PP} was 480 mV.

Moreover, as an example for comparison, the receiver 90 of the conventional example 1 which is considered to be ideal for a clamping performance, was made for an experimental purpose by letting the capacitance value of the capacitor C1 to be 3300 pF, using diodes of same type as the diodes D1 and D2 described above, as the diodes D3 and D4, and letting the other conditions to be the same. Furthermore, a low-frequency signal of the same conditions was induced in the antenna 1. In this case, the waveform at the input terminal of the high-frequency amplifier 3 was as a waveform shown in Fig. 3, and the maximum-minimum amplitude VR_{PP} was 450 mV.

Accordingly, it was substantiated that an performance of optimization of the level of the signal which is input to the high-frequency amplifier 3 in the receiver 10 is not inferior as compared to the case of the receiver 90 in the conventional example 1.

As it has been described above, in the signal attenuation circuit 12 of this embodiment, for the high-frequency signal received by the antenna 1, the high-frequency signal is attenuated by an attenuation factor according to the impedance of the diodes D1 and D2 determined by the size of the attenuation factor control signal. On the other hand, when the low-frequency interference such as the power-transmission line interference is generated, and the amplitude of the signal induced in the antenna 1 fluctuates substantially at the low frequency, the voltage of the low-frequency signal which is originated from the low-frequency interference is clamped by the circuit which is formed by the resistor R11 and the diode D1, or the circuit which is formed by the resistor R11, the diode D2, and the resistor R12.

Consequently, according to the signal attenuation circuit 12 of this embodiment, it is possible to optimize the level of the signal which is input to the subsequent high-frequency amplifier 3, while suppressing an increase in the number of rectifier means such as a diode, in the receiver 10. Moreover, according to the signal attenuation circuit 12 of this embodiment, it is possible to contribute to the automatic gain control and to take measures against the low-frequency interfering waves.

The present invention is not restricted to the embodiment described above, and various modifications are possible. For example, it is possible to modify the following first modified example to third example.

### <First modified embodiment>

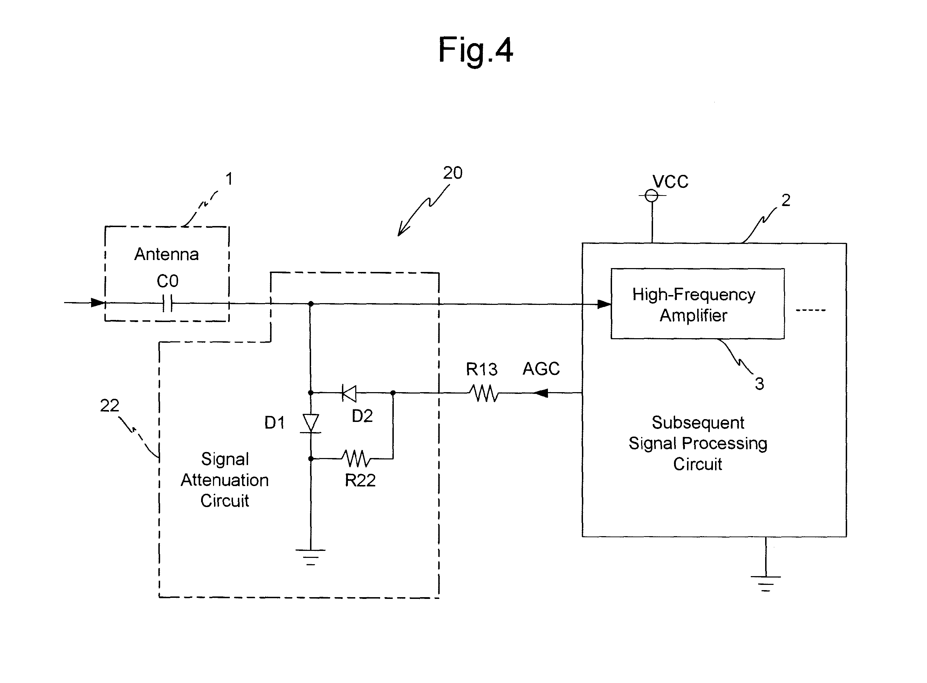

It is possible to adopt a signal attenuation circuit 22 of the first modified embodiment, instead of the signal attenuation circuit 12, as in a receiver 20 shown in Fig. 4. This signal attenuation circuit 22 comprises the diode D1, the diode D2, and a resistor R22. The cathode terminal of the diode D1 is grounded, the anode terminal of the diode D1 is connected to the signal output terminal of the antenna 1 and the cathode terminal of the diode D2. Moreover, the attenuation factor control signal AGC is input to the anode terminal of the diode D2 via the resistor R13. Furthermore, one terminal of the resistor R22 is grounded and the other terminal of the resistor R22 is connected to the anode terminal of the diode D2. A resistance value of the resistor R22 is let to be a resistance value about the same as the resistance value of the resistor R12 in the embodiment described above. In other words, a feature of the signal attenuation circuit 12, as compared to the signal attenuation circuit 20, is at a point that the anode terminal of the diode D1 is connected directly to the signal output terminal of the antenna 1.

In the receiver 20 structured in this manner, a high-frequency signal which is to be processed by the subsequent signal processing circuit 2, such as a broadcast-wave signal which is induced in the antenna 1, is input to the high-frequency amplifier 3 after the attenuation operation according to the size of the attenuation factor control signal AGC is performed, similarly as in the case of the receiver 10 described above.

On the other hand, when the signal induced in the antenna 1 is a signal on which, a low-frequency signal having a large amplitude due to the low-frequency interference such as the transmission line interference is superimposed, during the period in which the low-frequency signal has a substantial voltage value on the positive side, the low-frequency signal is clamped by the diode D1. Moreover, during the period in which the low-frequency signal has a substantial voltage value on the negative side, the low-frequency signal is clamped by a circuit which is formed by the diode D2 and the resistor R22. As a result of this, even when the signal induced in the antenna 1 is a signal on which the low-frequency signal having a large amplitude is superimposed, the level of the signal which is input to the high-frequency amplifier 3 is in a proper range of the input signal level for the high-frequency amplifier 3.

### <Second modified embodiment>

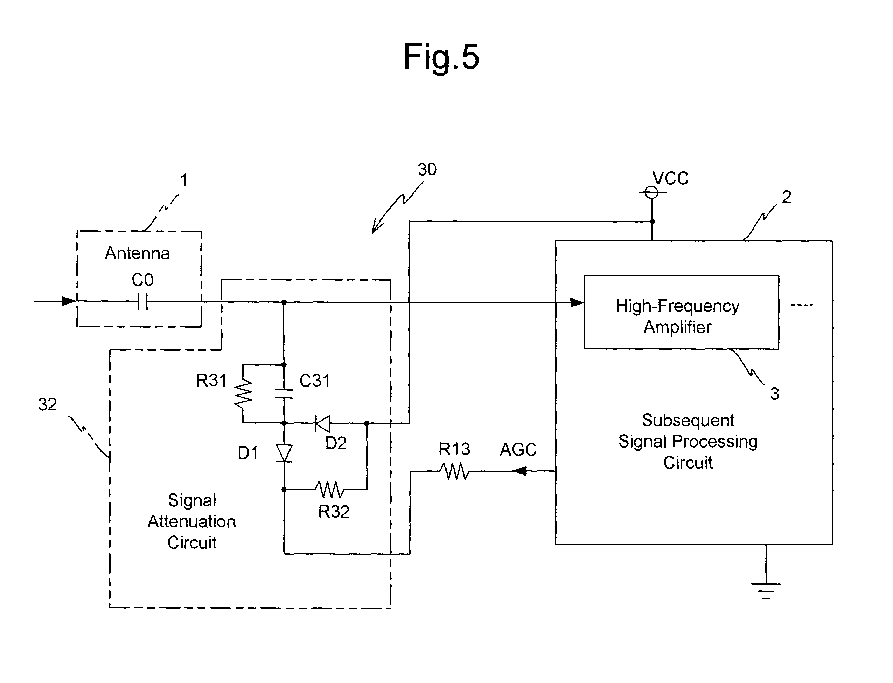

It is possible to adopt a signal attenuation circuit 32 of the second modified embodiment, instead of the signal attenuation circuit 12, as in a receiver 30 shown in Fig. 5.

The signal attenuation circuit 32 comprises the diode D1, the diode D2, a capacitor C31, a resistor R31, and a resistor R32. Here, the anode terminal of the diode D2 is connected to a power-supply voltage level (VCC) which is an alternating ground level, and the cathode terminal of the diode D2 is connected to the anode terminal of the diode D1. The attenuation factor control signal AGC is input to the cathode terminal of the diode D1 via the resistor R13.

One terminal of the capacitor C31 is connected to the signal output terminal of the antenna and the signal input terminal of the high-frequency amplifier 3 of the subsequent signal processing circuit 2, and the other terminal of the capacitor C31 is connected to the anode terminal of the diode D1. Moreover, one terminal of the resistor R31 is connected to the signal output terminal of the antenna 1 and the signal input terminal of the high-frequency amplifier 3 of the subsequent signal processing circuit 2, and the other terminal of the resistor R31 is connected to the anode terminal of the diode D1. Furthermore, one terminal of the resistor R32 is connected to the power-supply voltage level, and the other terminal of the resistor R32 is connected to the cathode terminal of the diode D1.

A capacitance value of the capacitor C31, a resistance value of the resistor R31, and a resistance value of the resistor R32 are let to be the values same as the capacitance value of the capacitor C11, the resistance value of the resistor R11, and the resistance value of the resistor R12 described above, respectively.

In the receiver 30 structured in such manner, the high-frequency signal which is to be processed by the subsequent signal processing circuit 2, such as the broadcast-wave signal which is induced in the antenna 1, is input to the high-frequency amplifier 3 after the attenuation operation according to the size of the attenuation factor control signal AGC is performed, similarly as in the case of the receiver 10 described above.

On the other hand, when the signal induced in the antenna 1 is signal on which, the low-frequency signal having a large amplitude due to the low-frequency interference such as the transmission line interference is superimposed, during the period in which the low-frequency signal has a substantial voltage value on the positive side with respect to the power-supply voltage level, the low-frequency signal is clamped by a circuit formed by the resistor R31, the diode D1, and the resistor R32. Moreover, during the period in which the low-frequency signal has a substantial voltage value on the negative side with respect to the power-supply voltage level, the low-frequency signal is clamped by a circuit formed by the resistor R31 and the diode D2. As a result of this, even when the signal induced in the antenna 1 becomes a signal on which the low-frequency signal having a large magnitude is superimposed, the level of the signal which is input to the high-frequency amplifier 3 is in a proper range of the input signal level for the high-frequency amplifier 3.

### <Third modified embodiment>

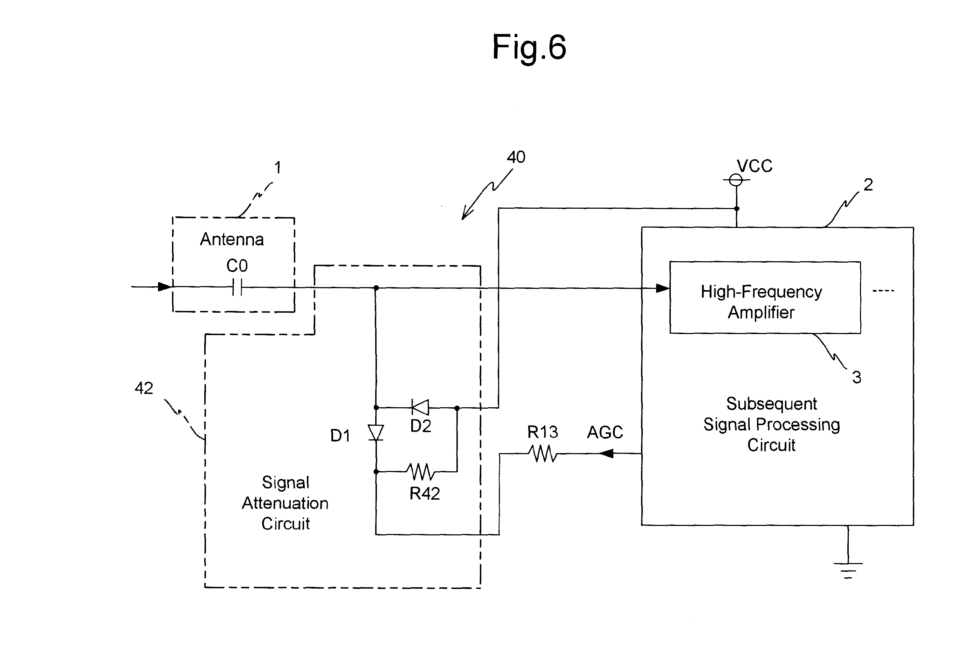

It is possible to adopt a signal attenuation circuit 42 of a third modified embodiment, instead of the signal attenuation circuit 12, as in a receiver 40 shown in Fig. 6. This signal attenuation circuit 42 of the third modified embodiment in which modifications similar to the modifications from the signal attenuation circuit 12 of the embodiment described above to the signal attenuation circuit 22 in of the first modified embodiment, are made in the signal attenuation circuit 32 of the second modified embodiment.

This signal attenuation circuit 42 comprises the diode D1, the diode D2, and a resistor R42. The anode terminal of the diode D2 is connected to the power-supply voltage level, and the cathode terminal of the diode D2 is connected to the signal output terminal of the antenna 1 and the anode terminal of the diode D1. Moreover, the attenuation factor control signal AGC is input to the cathode terminal of the diode D1 via the resistor R13. Furthermore, one terminal of the resistor R42 is connected to the power-supply voltage level, and the other terminal of the resistor R42 is connected to the cathode terminal of the diode D1. A resistance value of the resistor R42 is let to be about the same as the resistance value of the resistor R32 in the third modified embodiment.

In the receiver 40 structured in such manner, the high-frequency signal which is to be processed by the subsequent signal processing circuit 2, such as the broadcast-wave signal which is induced in the antenna 1, is input to the high-frequency amplifier 3 after the attenuation operation according to the size of the attenuation factor control signal AGC is performed, similarly as in the case of the receiver 30 described above.

On the other hand, when the signal induced in the antenna 1 is a signal on which, the low-frequency signal having a large amplitude due to the low-frequency interference such as the transmission line interference is superimposed, during the period in which the low-frequency signal has a substantial voltage on the positive side with respect to the power-supply voltage level, the low-frequency signal is clamped by a circuit formed by the diode D1 and the resistor R42. Moreover, during the period in which the low-frequency signal has a substantial voltage value on the negative side with respect to the power-supply voltage level, the low-frequency level signal is clamped by the diode D2. As a result of this, even when the signal induced in the antenna 1 becomes a signal on which the low-frequency signal having a large amplitude is superimposed, the level of the signal which is input to the high-frequency amplifier 3 is in a proper range of the input signal level for the high-frequency amplifier 3.

In the embodiment and the first modified embodiment to the third modified embodiment, an element which performs clamping of the low-frequency signal having the large amplitude in combination with a diode is let to be a resistor. However, any element can be adopted as the resistor, provided that the element satisfies a selection criteria described in the description of the embodiment.

Moreover, in the embodiment and the first modified embodiment to the third modified embodiment, diodes are used. However, any element having a rectification effect similar to the diode can be used instead of the diode.

Furthermore, in the embodiment and the first modified embodiment to the third modified embodiment, the present invention is applied to a signal attenuation circuit mounted in a receiver such as a radio receiver. However, as a matter of course, it is possible to apply the present invention to an attenuation circuit which is mounted in a signal processing apparatus other than the receiver.

## Claims

1. A signal attenuation circuit which attenuates a signal from a signal source, and sends an attenuated signal to a subsequent signal processing circuit, comprising:
a first rectifier means which has one terminal which is connected to an output terminal of the signal source and an input terminal of the subsequent signal processing circuit, via a first impedance, and the other terminal which is connected to an alternating ground level via a second impedance, and for which, an impedance changes according to a size of an attenuation factor control signal; and
a second rectifier means which has one terminal which is connected to the alternating ground level via a third impedance, and the other terminal which is connected to one terminal of the first rectifier means, and which is connected in series to the first rectifier terminal in a rectification direction, and for which, an impedance changes according to the size of the attenuation factor control signal, wherein
the first impedance, the second impedance, and the third impedance are determined upon considering an attenuation of the signal from the signal source, by a change in an impedance of the first rectifier means and the second rectifier means, according to a size of the attenuation factor control signal, in a high-frequency region in which the subsequent signal processing circuit has to perform processing, and are determined upon considering a proper range of an input signal level of the subsequent signal processing circuit and the impedance of the signal source, in a low-frequency region in which a low-frequency interference may be generated,

2. The signal attenuation circuit according to claim 1, wherein
the signal output terminal of the signal source and the one terminal of the first rectifier means are connected via a capacitive element, and is connected in parallel to a connection made via the capacitive element, via a resistive element.

3. The signal attenuation circuit according to claim 1, wherein
the signal output terminal of the signal source, and the one terminal of the first rectifier means are connected directly, and the first impedance is substantially zero.

4. The signal attenuation circuit according to claim 1, wherein
the other terminal of the first rectifier means and the alternating ground level are connected directly, and the second impedance is substantially zero.

5. The signal attenuation circuit according to claim 1, wherein
the one terminal of the second rectifier means and the alternating ground level are connected directly, and the third impedance is substantially zero.

6. The signal attenuation circuit according to claim 1, wherein
the first rectifier means and the second rectifier means are diodes.
